# EUROPEAN PATENT SPECIFICATION

(11) **EP 0 408 779 B1**
(45) Date of publication and mention of the grant of the patent: **17.03.1993**
(21) Application number: 89113119.5
(22) Date of filing: 18.07.1989
(51) Int. Cl.: H01L 25/065, H01L 23/495

(54) **High density semiconductor memory module**
Halbleiter-Speichermodul höher Dichte
Module semi-conducteur de mémoire à haute densité

(43) Date of publication of application: 23.01.1991
(73) Proprietor: International Business Machines Corporation, Armonk, N.Y. 10504 (US)
(72) Inventor: Klink, Erich, Dipl.-Ing., D-7036 Schönaich (DE); Kohler, Helmut, Dipl.-Ing., D-7256 Mönsheim (DE); Pross, Harald, Dipl.-Ing., D-7277 Wildberg 4 (DE)
(74) Representative: Mönig, Anton, Dipl.-Ing.

(56) References cited:
- EP-A- 0 221 496
- FR-A- 2 295 686
- US-A- 3 689 684
- PATENT ABSTRACTS OF JAPAN, vol. 7, no. 239 (E-206)[1384], 25th October 1983;& JP-A-58 130 553
- IBM TECHNICAL DISCLOSURE BULLETIN, vol. 24, no. 12, May 1982, page 6371, New York, US; M.L. BULLER et al.: "Back-to-back chip pack"

## Description

The present invention relates to high density semiconductor memory modules, and more particularly to a method for forming semiconductor memory modules, and a semiconductor memory module.

A substantial part of the cost of manufacturing computer systems directly depends upon the space occupied by the integrated circuit chips used to fabricate the systems. Thus it is important to minimize the size of semiconductor memory modules in dual inline packages which increasingly are used in modern computer systems.

One structure to increase the chip packaging density is formed by mounting or stacking one chip on top of another one. Prior art shows examples of stacking chips to form double-chip structures in which chips are contained within a rigid housing, with the back of one chip facing the back of the second chip, there being a rigid support between the chips on which the back of the chips rests. The active faces are directed away from each other to permit easy electrical connection to the exposed input/output (I/O) terminals on each chip.

JP-A-58 130 553 describes a device where two chips are attached on both surfaces of a frame bed.

JP-A-56-137665 describes a dual inline package module (DIP) containing two pairs of semiconductor chips, each chip having solder mounds on its active face for electrical connection to the circuits within the chips. The active faces of the chips of one pair are mounted facing each other with solder mounds on one chip aligned with corresponding solder mounds of the other chip. The two pairs are stacked by facing the back of the upper chip of the first pair with the back of the lower chip of the second pair.

The invention as claimed therefore solves the object of providing a method and a memory module which allow the duplication of the memory module density with a minimum increase of the module size and with low manufacturing costs.

Accordingly, the method of this invention uses well-known techniques to provide a double density memory module. These techniques are used in the manufacturing of DIP modules containing only one chip inside the moulded plastic housing or ceramic housing. Commonly these chips are produced by employing a thin metal carrier tape which is punched for providing lead frames with spaced series of beam lead patterns which comprise inner bond leads to be bonded to the chip pads and outer bond leads to form the contact pins. Subsequently the chips are connected to the inner bond leads. This is usually realized by first gluing the chip to the inner bond leads and then bonding the chip pads to the inner bond leads, but other ways of connecting are also possible. Next, the housing is formed and the outer leads are punched to correct the length of the contact pins or contact leads. Several tests of the modules are usually carried out during the manufacturing process.

Contrary to the common methods for manufacturing memory modules, the inner bond leads are punched in the method according to the invention so that they have a greater width than the common inner bond leads. Subsequently, or together with the punching step the inner bond leads are slotted or treated in any other appropriate manner in order to allow the bending of at least one of each of the smaller inner bond leads obtained before for providing a space between the two inner bond leads. The inner bond leads are preferably slotted only in the area of the inner lead bond ends as far as necessary to obtain a sufficient gap for inserting the chips. Next, two semiconductor memory chips having an active and a back face are glued together back-to-back. Gluing can be accomplished by any appropriate material which is well known to a person skilled in the art. Afterwards the chips stacked together back-to-back are inserted in the gap between the upper inner bond leads and the lower inner bond leads so that the upper and lower bond leads embrace the two chips. The chips can be equal with the pad occupation or mirrored. In the first case the respective inner lead bond ends and the chip pads have to be bonded, e.g. by wire-bonding with intersections for accomplishing a corresponding connection. In the second case the inner lead bond ends can be bonded directly to the respective chip pads. Then, the top chip must be shifted relative to the bottom chip for adjusting the chip pads to the respective inner bond leads and for compensating the displacement of the upper smaller inner bond leads and the lower smaller inner bond leads if the displacement is not compensated by buckling of the upper and/or lower smaller inner bond leads.

The method according to the invention is applicable to dual inline package (DIP) as well as to ZIG-ZAG package, where the two chips are arranged in a vertical position and the clamplike bond leads embrace the memory chips only in the lower part.

The handling of the module after fixing the chips to the bond leads corresponds to the common methods for the manufacturing of memory modules.

The method according to the invention has the advantage that only few additional manufacturing steps are necessary to provide a memory module with double density. Thus known techniques can be use of thus allowing a low cost manufacturing of memory modules.

Another advantage is the height of the modules which is in the range of the common single chip modules. So the density of printed circuit boards on which the memory modules are arranged can be doubled or the assembly of the printed circuit board can be reduced, which in turn leads to a reduction of manufacturing costs.

The semiconductor memory module according to this invention comprises a housing of plastic or ceramic in which two chips are stacked together back-to-back. The pads of the chips are electrically connected to bond leads which comprise outer bond leads generally arranged outside the housing to form the contact pins or contact leads of the module to a printed circuit board, and inner bond leads in the housing. The inner bond leads are spread in the area of the inner lead bond ends into upper and lower bond leads forming a gap for receiving and embracing the stacked chips. The upper and lower lead beams may run into a lead beam part which is also arranged inside the housing and subsequently passes over to the outer lead bond arranged outside the housing. Preferably, the upper and lower inner bond leads have a smaller width than the lead beam part before leaving the housing.

The inner bond leads can be formed by using a metal carrier tape having at least in the area of the inner bond leads a double sheet material so that after punching the lead beams an upper and a lower inner lead beam end arranged one above the other is provided. Another method for forming the clamplike inner bond leads is the method according to the invention and as described above, for example.

For better understanding of the present invention, together with further objects, advantages and features thereof, a preferred embodiment of the invention is described in the following with reference to the accompanying drawings, in which:
Fig. 1 is a view of a dual inline package module with a part of the housing broken away and showing the top chip;
Fig. 2 is a top view of Fig. 1;
Fig. 3 is a top view of inner and outer bond leads with lead frame; and
Fig. 4 is a cross-sectional view of a double-chip stack.

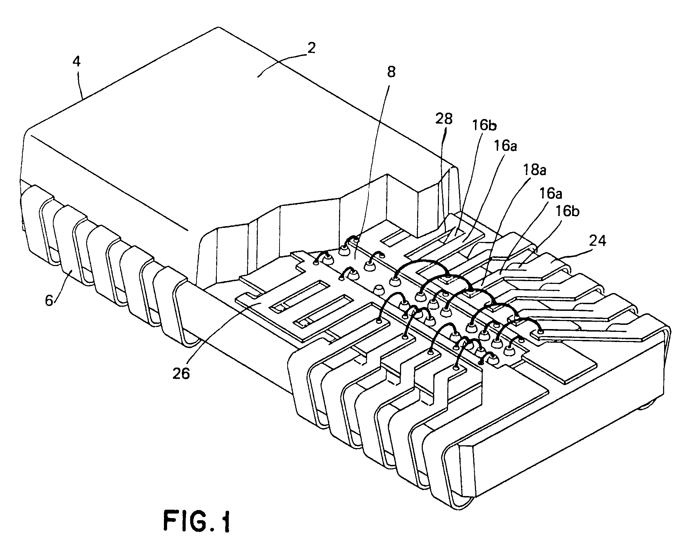

Fig. 1 shows a semiconductor memory module 2 of the DIP-type comprising a plastic housing 4, and outer bond leads 6 usually on both sides outside the housing 4 and formed as J-leads for surface mounting of the memory module on a printed circuit board (not shown). Part of the top portion of the housing is broken away and shows the top chip 8. The pads 20 of the chip 8 are wire-bonded with inner bond lead ends 18a of the upper inner bond leads 16a. The lower inner bond leads 16b which are connected to the pads of the bottom chip 10, and the upper inner bond lead 16a join in the inner bond lead part 24 which is located inside the housing. The bottom chip 10 is not visible in this depiction. The power supply 26 and the ground supply 28 both comprise upper and lower inner bond leads 16a and 16b, respectively, but the inner bond lead part 24 is not connected to outer bond leads. In the preferred embodiment three inner bond leads are interconnected to provide appropriate power and ground supply.

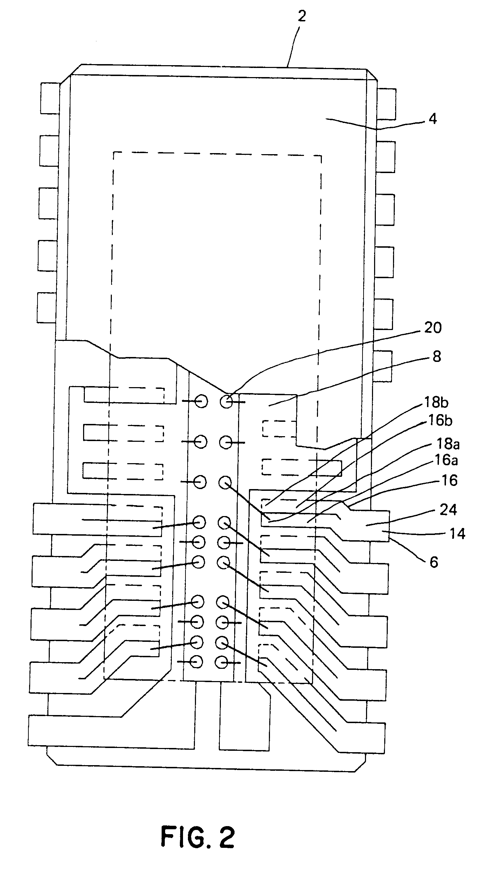

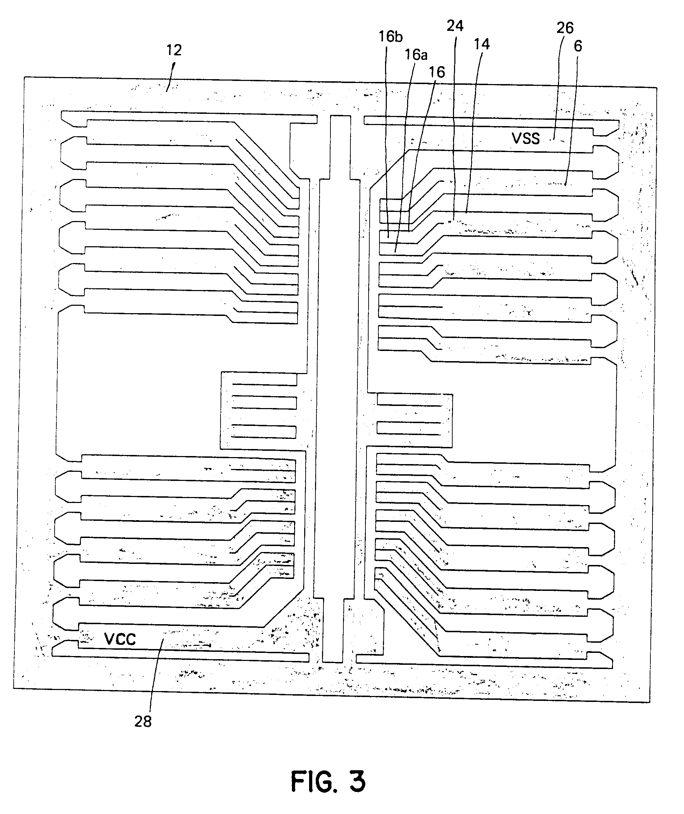

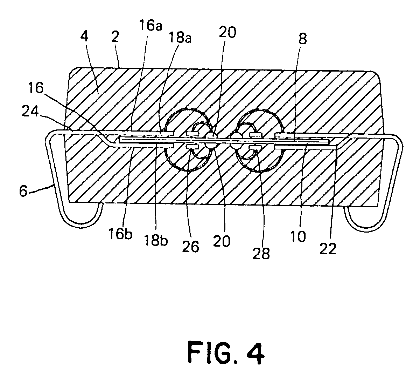

Fig. 2 is a top view of Fig. 1. Not visible parts are depicted with broken lines. Beam leads 14 comprising inner bond leads 16 and outer beam leads 6 (Fig. 3) are fixed with the inner bond leads 16 to the chips 8, 10 (chip 10 is shown in Fig. 4) and with the outer bond leads 6 to a lead frame 12. The lead frame 12 (Fig. 3) usually serves for positioning the beam leads and the chips and will be removed for providing the J-leads in a further punching and bending step. The inner bond leads 16 comprise an upper bond lead 16a and lower bond lead 16b, at least one of which is bent so that they embrace the top chip 8 and the bottom chip 10. The inner bond lead ends 18a and 18b of the respective upper and lower bond leads are wire-bonded with chip pads 20. The upper inner bond lead 16a and the lower inner bond lead 16b have a smaller width than the part 24 of the inner bond lead 16.

Fig. 3 shows the lead frame 12 with the outer bond leads 6 which are later punched and formed to contact pins.

The chips 8 and 10 stacked together back-to-back with the inner bond lead 16 and the inner bond leads 16a and 16b whose ends 18a and 18b, respectively, are connected by wire-bonding to the pads 20 of the top chip 8 and the bottom chip 10, respectively, are shown in Fig. 4 in a cross-sectional view.

The memory module of the preferred embodiment as shown in the drawings is manufactured in accordance with the inventive method as described above. Thus the inner bond leads 16 are slotted at least in the area of the inner bond lead ends 18 after or during the punching step. Subsequent to the punching step the slotted ends are spread to form a gap 22 in which the stacked chips 8 and 10 are inserted after having been glued together back-to-back. Then the ends 18a and 18b are wire-bonded to the chip pads 20. The further steps of the method correspond to common steps for manufacturing modules of the DIP or ZIG ZAG type.

Both memory chips should be accessed exclusively by seperate chip select pins and all other pins like data lines, address lines, etc. are commonly used by the top chip and the bottom chip.

## Claims

1. A method for forming high density semiconductor memory modules (2) comprising the following steps:
providing a thin sheet metal carrier;
punching of said thin sheet metal carrier for providing a lead frame (12) with a spaced series of beam lead patterns, which beam leads (14) comprise inner bond leads (16) to be bonded to chip pads and at least some outer bond leads (6) to form contacts;
slotting at least some of said inner bond leads for providing a pair of smaller inner bond leads (16a, 16b) per beam lead;
bending at least one of each of said pair of smaller inner bond leads for providing a space (22) between the top of the lower one of said pair of smaller inner bond leads and the bottom of the upper one of said smaller inner bond leads sufficient to receive two chips (8, 10) which are stacked together with their flat surfaces;
gluing said chips together back-to-back forming a stack with a bottom and a top chip;
inserting said chips stacked together back-to-back into said space (22) between the lower and the upper smaller inner bond leads;
connecting said stacked chips to said bond leads by bonding the pads of said bottom chip (10) to said lower smaller inner bond leads (16b) and the pads of said top chip (8) to said upper smaller inner bond leads (16a);
molding the housing (4) round the chips and the inner bond leads (16); and
preparing the outer bond leads (6) to provide contact pins or leads.

2. The method as claimed in claim 1, further comprising shifting said top chip (8) relative to said bottom chip (10) for adjusting the chip pads to the respective inner bond leads.

3. The method as claimed in claim 1 or 2, wherein the bonding of the pads of said bottom chip to said lower smaller inner bond leads and the bonding of the pads of said top chip to said upper smaller inner bond leads are accomplished by wire-bonding.

4. The method as claimed in any one of the preceding claims wherein prior to bonding said pads to said inner bond leads said stacked chips are fixed to said bond leads.

5. The method as claimed in any one of the preceding claims wherein preparing the outer bond leads to provide contact pins or leads includes
punching the outer bond leads to correct the length and to remove said lead frame; and
bending said outer bond leads to form the contact pins or leads.

6. A semiconductor memory module comprising
a housing (4);
two chips (8, 10) stacked together back-to back in said housing;
beam leads (14) electrically connected to the pads (20) of said stacked chips by wire-bonding, which beam leads comprise outer bond leads (6) substantially outside said housing and inner bond leads (16) in said housing, which inner bond leads are spread into upper inner bond leads (16a) and lower inner bond leads (16b) forming a gap (22) for receiving said stacked chips.

7. The semiconductor memory module as claimed in claim 6 wherein said upper (16a) and said lower (16b) inner bond leads run into an inner bond lead part (24) having a greater width than said upper and lower inner bond leads.

## Patentansprüche

1. Verfahren zur Herstellung von Halbleiter-Speichermodulen hoher Dichte (2), das folgende Schritte umfaßt:
Herstellen eines dünnen Blechträgers;
Stanzen des dünnen Blechträgers, um einen Anschlußrahmen (12) mit einer mit Zwischenraum angeordneten Reihe von Anschlußmustern herzustellen, wobei die Anschlüsse (14) innere Bond-Anschlüsse (16) zum Bonden mit den Chip-Kontaktflächen und mindestens einige Kontakte bildende äußere Anschlüsse (6) umfassen;
Spalten mindestens einiger der inneren Bond-Anschlüsse, um ein Paar kleinere innere Bond-Anschlüsse (16a, 16b) pro Anschluß herzustellen;
Biegen mindestens eines der beiden kleineren inneren Bond-Anschlüsse, um einen ausreichend grossen Zwischenraum (22) zwischen der Oberseite des unteren der beiden kleineren inneren Bond-Anschlüsse und der Unterseite des oberen der beiden kleineren inneren Bond-Anschlüsse zu schaffen, um zwei Chips (8, 10) aufzunehmen, die übereinander an ihren ebenen Flächen gestapelt sind;
Zusammenkleben der Chips an den Rückseiten, um einen Stapel aus einem oberen und einem unteren Chip zu bilden;
Einführen des Stapels der an den Rückseiten zusammengefügten Chips in den Zwischenraum (22) zwischen den unteren und den oberen kleineren inneren Bond-Anschlüssen;
Verbinden der gestapelten Chips mit den Bond-Anschlüssen durch Bonden der Kontaktflächen des unteren Chips (10) an die unteren kleineren inneren Bond-Anschlüsse (16b) und der Kontaktflächen des oberen Chips (8) an die oberen kleineren inneren Bond-Anschlüsse (16a);
Formen des Gehäuse (4) um die Chips und die inneren Anschlüsse (16); und
Bearbeiten der äußeren Anschlüsse (16), um Kontaktstifte oder -anschlüsse herzustellen.

2. Verfahren nach Anspruch 1, das außerdem das Verschieben des oberen Chips (8) gegenüber dem unteren Chip (10) enthält, um die Chip-Kontaktflächen auf die entsprechenden inneren Bond-Anschlüsse auszurichten.

3. Verfahren nach Anspruch 1 oder 2, bei dem das Bonden der Kontaktflächen des unteren Chips an die unteren kleineren inneren Bond-Anschlüsse sowie der Kontaktflächen des oberen Chips an die oberen kleineren inneren Bond-Anschlüsse durch Draht-Bonden erfolgt.

4. Verfahren nach einem der vorigen Ansprüche, bei dem die gestapelten Chips mit den Bond-Anschlüssen fest verbunden werden, bevor das Bonden der Chip-Kontaktflächen mit den inneren Bond-Anschlüssen erfolgt.

5. Verfahren nach einem der vorigen Ansprüche, bei dem das Bearbeiten der äußeren Anschlüsse, um Kontaktstifte oder -anschlüsse herzustellen,
das Stanzen der äußeren Anschlüsse, um die Länge zu korrigieren und den Anschlußrahmen zu entfernen, und
das Biegen der äußeren Anschlüsse zur Bildung der Kontaktstifte oder -anschlüsse umfaßt.

6. Halbleiter-Speichermodul, das folgendes umfaßt:
ein Gehäuse (4);
zwei im Gehäuse an den Rückseiten zusammengefügte gestapelte Chips (8, 10);
Anschlüsse (14), die mit den Kontaktflächen (20) der gestapelten Chips durch Draht-Bonden elektrisch verbunden sind, und welche äußere, weitgehend außerhalb des Gehäuses befindliche Anschlüsse (6) und innere Bond-Anschlüsse (16) im Gehäuse umfassen, wobei die inneren Bond-Anschlüsse in obere (16a) und untere (16b) innere Bond-Anschlüsse geteilt sind, um einen Zwischenraum (22) zur Aufnahme der gestapelten Chips zu bilden.

7. Halbleiter-Speichermodul nach Anspruch 6, in dem die oberen (16a) und unteren (16b) inneren Bond-Anschlüsse in einen inneren Bond-Anschlußteil (24) übergehen, der breiter ist als die oberen und unteren inneren Bond-Anschlüsse.

## Revendications

1. Procédé pour la réalisation de modules de mémoire à semi-conducteurs à haute densité (2) comprenant les étapes suivantes :
la fourniture d'un support métallique en feuille mince ;
le découpage dudit support métallique en feuille mince pour créer une grille de connexion (12) avec une série espacée de dessins de conducteurs en faisceau, lesquels conducteurs en faisceau (14) comprennent des conducteurs de liaison intérieure (16) destinés à être reliés à des plots de puce et au moins quelques conducteurs de liaison extérieure (6) pour former des contacts ;
la refente d'au moins quelques uns desdits conducteurs de liaison intérieure pour créer une paire de conducteurs de liaison intérieure plus petits (16a, 16b) par conducteur en faisceau ;
le cintrage d'au moins l'un des conducteurs de liaison intérieure plus petits de chacune desdites paires pour créer un espace (22) suffisant entre le dessus du conducteur inférieur des conducteurs de liaison intérieure plus petits de ladite paire et le dessous du conducteur supérieur desdits conducteurs de liaison intérieure plus petits pour recevoir deux puces (8, 10) qui sont empilées ensemble sur leurs faces plates ;
le collage desdites puces en même temps dos à dos pour former un empilage avec une puce inférieure et une puce supérieure ;
l'insertion desdites puces empilées ensemble dos à dos dans ledit espace (22) entre les conducteurs inférieurs et les conducteurs supérieurs des conducteurs de liaison intérieure plus petits ;
la connexion desdites puces empilées auxdits conducteurs de liaison en reliant les plots de ladite puce inférieure (10) auxdits conducteurs inférieurs de liaison intérieure plus petits (16b) et les plots de ladite puce supérieure (8) auxdits conducteurs supérieurs de liaison intérieure plus petits (16a) ;
le moulage du boîtier (4) autour des puces et des conducteurs de liaison intérieure (16) ; et
la préparation des conducteurs de liaison extérieure (6) pour créer des pattes, ou conducteurs, de contact.

2. Procédé selon la revendication 1, comprenant de plus le décalage de ladite puce supérieure (8) par rapport à ladite puce inférieure (10) pour le réglage des plots de puce par rapport aux conducteurs de liaison intérieure respectifs.

3. Procédé selon la revendication 1 ou 2, dans lequel la liaison des plots de ladite puce inférieure auxdits conducteurs inférieurs de liaison intérieure plus petits et la liaison des plots de ladite puce supérieure auxdits conducteurs supérieurs de liaison intérieure plus petits sont réalisées par liaison câblée.

4. Procédé selon l'une quelconque des revendications précédentes, dans lequel avant de réaliser la liaison desdits plots auxdits conducteurs de liaison intérieure, lesdites puces empilées sont fixées auxdits conducteurs de liaison.

5. Procédé selon l'une quelconque des revendications précédentes, dans lequel la préparation des conducteurs de liaison extérieure pour créer des pattes, ou conducteurs, de contact comprend :
le découpage desdits conducteurs de liaison extérieure pour corriger la longueur et retirer ladite grille de connexion ; et
le cintrage desdits conducteurs de liaison extérieure pour constituer les pattes, ou conducteurs, de contact.

6. Module de mémoire à semi-conducteurs comprenant :
un boîtier (4) ;
deux puces (8, 10) empilées ensemble dos à dos dans ledit boîtier ;
des conducteurs en faisceau (14) reliés électriquement par liaison câblée aux plots (20) desdites puces empilées, lesquels conducteurs en faisceau comprennent des conducteurs de liaison extérieure (6) essentiellement à l'extérieur dudit boîtier et des conducteurs de liaison intérieure (16) dans ledit boîtier, lesquels conducteurs de liaison intérieure sont séparés en conducteurs supérieurs de liaison intérieure (16a) et en conducteurs inférieurs de liaison intérieure (16b), en formant un espace (22) pour recevoir lesdites puces empilées.

7. Module de mémoire à semi-conducteurs, selon la revendication 6, dans lequel lesdits conducteurs de liaison intérieure inférieurs (16a) et supérieurs (16b) passent dans une partie de conducteur de liaison intérieure (24) ayant une largeur plus grande que celle desdits conducteurs de liaison intérieure supérieurs et inférieurs.
